# EUROPÄISCHE PATENTSCHRIFT

(11) **EP 1 869 312 B1**
(45) Veröffentlichungstag und Bekanntmachung des Hinweises auf die Patenterteilung: **28.10.2009**
(21) Anmeldenummer: 06708546.4
(22) Anmeldetag: 28.02.2006
(51) Int. Cl.: F02M 63/00, H01L 41/053, F02M 59/46, F02M 51/06, F02M 55/00

(54) **PIEZOAKTOR MIT LABYRINTHDICHTUNG**
PIEZOELECTRIC ACTUATOR WITH A LABYRINTH SEAL
ACTIONNEUR PIEZOELECTRIQUE DOTE D'UNE GARNITURE D'ETANCHEITE EN LABYRINTHE

(30) Priorität: 04.04.2005 DE 102005015256
(43) Veröffentlichungstag der Anmeldung: 26.12.2007
(73) Patentinhaber: ROBERT BOSCH GMBH, 70442 Stuttgart (DE)
(72) Erfinder: BOECKING, Friedrich, 70499 Stuttgart (DE)
(86) Internationale Anmeldenummer: PCT/EP2006/060317
(87) Internationale Veröffentlichungsnummer: WO 2006/106016

(56) Entgegenhaltungen:
- WO-A-2004/081368
- DE-A- 10 040 239
- DE-A1- 19 727 992
- DE-A1- 19 818 475
- US-A- 4 553 059

## Beschreibung

### Stand der Technik

Die Erfindung geht aus von einem Piezoaktor nach der Gattung des Patentanspruchs 1.

Ein solcher Piezoaktor ist beispielsweise durch die DE 101 23 173 A1 bekannt geworden.

Bei diesem bekannten Piezoaktor ist eine Membran vorgesehen, um das Piezoelement von einer zu steuernden Flüssigkeit abzudichten.

Seit langem wird nach einer konstruktiv einfachen Lösung gesucht, den Piezoaktor vollständig in einer Flüssigkeit, z.B. den Piezoaktor eines Kraftstoffeinspritzventils vollständig im Kraftstoff, anzuordnen und gleichzeitig das Piezoelement bei unterschiedlichen Temperaturen gegenüber dem Kraftstoff zuverlässig abzudichten. Der Einsatz von Kunststoffen zur Abdichtung ist problematisch, da Kunststoffe in Abhängigkeit der Temperatur sehr unterschiedliche Eigenschaften haben und aufgrund ihrer thermischen Ausdehnung entweder nur bei hohen oder nur bei tiefen Temperaturen wirkungsvoll abdichten können.

Weitere Piezoaktoren sind aus dem Dokumenten DE 100 40 239, De 198 18475, US 455 3059 oder DE 197 27 992 bekannt.

### Vorteile der Erfindung

Der erfindungsgemäße Piezoaktor mit den kennzeichnenden Merkmalen des Patentanspruchs 1 hat demgegenüber den Vorteil, dass die Kunststoffdichtung das durch die Nuten gebildete Labyrinth bei hohen Temperaturen axial und bei niedrigeren Temperaturen radial abdichtet. Erfindungsgemäß wird also eine "Labyrinthdichtung" mit optimierter Dichtwirkung, insbesondere für die Kraftstoffisolation des Piezoaktors eines Kraftstoffeinspritzventils, bereit gestellt.

Weitere Vorteile und vorteilhafte Ausgestaltungen des Gegenstands der Erfindung sind der Beschreibung, der Zeichnung und den Ansprüchen entnehmbar.

### Zeichnungen

Ein Ausführungsbeispiel des erfindungsgemäßen Piezoaktors ist in den Zeichnungen dargestellt und in der nachfolgenden Beschreibung näher erläutert. Es zeigen:
- Fig. 1: den erfindungsgemäßen Piezoaktor mit einer Kunststoffdichtung;
- Fig. 2: die Ausdehnung der Kunststoffdichtung bei hohen Temperaturen (Fig. 2a) und bei niedrigen Temperaturen (Fig. 2b) in einer Detailansicht gemäß II in Fig. 1; und
- Fig. 3: die Draufsicht auf die Stirnseite des in Fig. 1 gezeigten Piezoaktors.

### Beschreibung der Ausführungsbeispiele

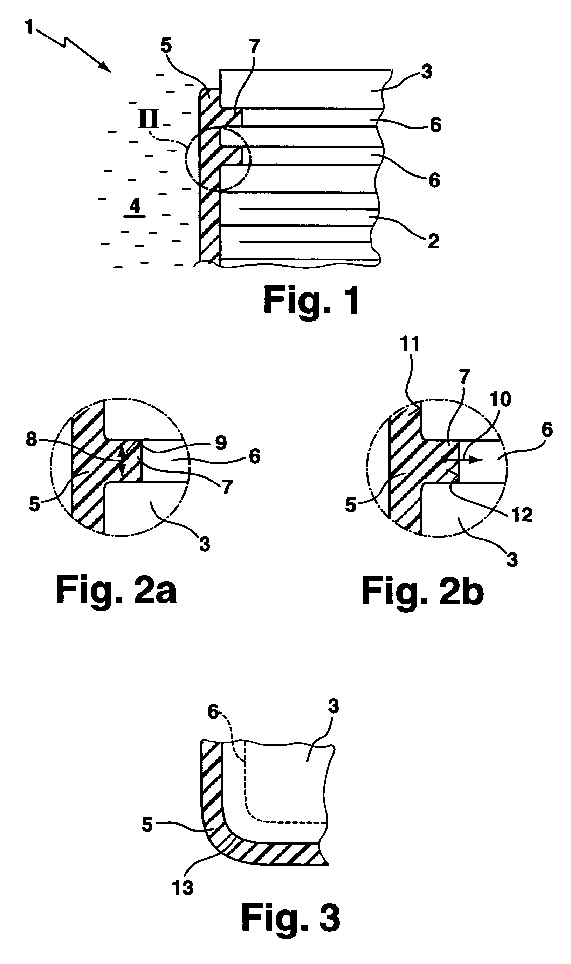

Der in **Fig. 1** gezeigte Piezoaktor **1** umfasst ein Piezoelement (Piezostapel) **2** und ein Kopf- oder Fußteil **3,** das stirnseitig am Piezoelement 2 angeordnet ist. Das Kopf-bzw. Fußteil 3 ist entweder Teil des Piezoelements 2.

Der Piezoaktor 1 ist von Kraftstoff **4** umgeben, wobei eine das Kopf- bzw. Fußteil 3 umgebende Kunststoffdichtung **5** das Piezoelement 2 gegenüber dem Kraftstoff 4 abdichtet. Dazu weist das Kopf- bzw. Fußteil 3 zwei umlaufende Nuten **6** auf, in welche die Kunststoffdichtung 5 jeweils mit radial nach innen gerichteten, umlaufenden Vorsprüngen **7** eingreift. Im gezeigten Ausführungsbeispiel erstreckt sich die Kunststoffdichtung 5 axial, d.h. nach unten, bis zum Piezoelement 2.

Die Kunststoffdichtung 5 dichtet das Piezoelement 2 bei hohen und bei niedrigen Temperaturen ab. Bei hohen Temperaturen dehnt sich die Kunststoffdichtung 5 insbesondere axial aus, wie in **Fig. 2a** durch den Doppelpfeil **8** angedeutet ist, und liegt dann dichtend an den beiden Nutflanken **9** der Nut 6 an. Bei niedrigen Temperaturen zieht sich die Kunststoffdichtung 5 insbesondere radial nach innen zusammen, wie in **Fig. 2b** durch den Pfeil **10** angedeutet ist, und liegt dann dichtend an der Mantelfläche **11** des Kopf- bzw. Fußteils 3 und/oder am Nutgrund **12** der Nut 6 an. Das durch die Nuten 6 gebildete Labyrinth wird durch die Kunststoffdichtung ("Labyrinthdichtung") 5 bei unterschiedlichen Temperaturen zuverlässig gegen den Kraftstoff 4 abgedichtet.

Wie in **Fig. 3** gezeigt, hat das Kopf- bzw. Fußteil 3 im gezeigten Ausführungsbeispiel einen eckigen Querschnitt mit gerundeten Ecken **13.**

## Patentansprüche

1. Piezoaktor (1), mit einem gegenüber einem Fluid (4) abgedichteten Piezoelement (2) mit einem Stirnseitig angeordneten Kopf- und/oder Fußteil (3)
**dadurch gekennzeichnet,**
**dass** das Kopf- bzw. Fußteil (3) mindestens eine umlaufende Nut (6) aufweist und von einer Kunststoffdichtung (5) umgeben ist, die mit einem radial nach innen gerichteten, umlaufenden Vorsprung (7) in die Nut (6) eingreift, so dass die Kunststoffdichtung (5) bei niedrigen Temperaturen radial innen dichtend an der Mantelfläche (11) des kopf-bzw. Fußteils (3) oder am Nutgrund (12) des Nut (6), bei hohen temperaturen durch Ausdehnung axial dichtend an den beiden Nutflanken (9) des Nut (6) anliegt.

2. Piezoaktor nach Anspruch 1, **dadurch gekennzeichnet, dass** der Vorsprung (7) die Nut (6) vollständig ausfüllt.

3. Piezoaktor nach Anspruch 1 oder 2, **dadurch gekennzeichnet, dass** das Kopf-bzw. Fußteil (3) einen eckigen Querschnitt mit gerundeten Ecken (13) hat.

4. Piezoaktor nach Anspruch 1 oder 2, **dadurch gekennzeichnet, dass** das Kopf-bzw. Fußteil (3) einen runden Querschnitt hat.

5. Piezoaktor nach einem der vorhergehenden Ansprüche, **dadurch gekennzeichnet, dass** das Kopf- bzw. Fußteil (3) mehrere umlaufende Nuten (6) aufweist und entsprechend die Kunststoffdichtung (5) mehrere Vorsprünge (7) aufweist.

6. Piezoaktor nach einem der vorhergehenden Ansprüche, **dadurch gekennzeichnet, dass** die Kunststoffdichtung (5) sich bis zum Piezoelement (2) erstreckt.

## Claims

1. Piezoactuator (1), with a piezoelement (2) sealed off with respect to a fluid (4) and having a head part and/or foot part (3) arranged on the end face, **characterized in that** the head part or foot part (3) has at least one peripheral groove (6) and is surrounded by a plastic seal (5) which engages with a radially inward-directed peripheral projection (7) into the groove (6), so that the plastic seal (5), at low temperatures, bears, sealing radially inwards, against the surface area (11) of the head part or foot part (3) or against the groove bottom (12) of the groove (6) and, at high temperatures, by expansion bears, sealing axially, against the two groove flanks (9) of the groove (6).

2. Piezoactuator according to Claim 1, **characterized in that** the projection (7) completely fills the groove (6).

3. Piezoactuator according to Claim 1 or 2, **characterized in that** the head part or foot part (3) has an angular cross section with rounded corners (13).

4. Piezoactuator according to Claim 1 or 2, **characterized in that** the head part or foot part (3) has a round cross section.

5. Piezoactuator according to one of the preceding claims, **characterized in that** the head part or foot part (3) has a plurality of peripheral grooves (6) and the plastic seal (5) correspondingly has a plurality of projections (7).

6. Piezoactuator according to one of the preceding claims, **characterized in that** the plastic seal (5) extends as far as the piezoelement (2).

## Revendications

1. Actionneur piézoélectrique (1), comprenant un élément piézoélectrique (2) rendu étanche vis-à-vis d'un fluide (4), comprenant une partie de tête et/ou une partie de base (3) disposée du côté frontal,
**caractérisé en ce que**
la partie de tête ou la partie de base (3) présente au moins une rainure périphérique (6) et est entourée par un joint d'étanchéité en plastique (5), qui vient en prise dans la rainure (6) avec une saillie (7) périphérique orientée radialement vers l'intérieur, de sorte que le joint d'étanchéité en plastique (5), en cas de basses températures, s'applique radialement à l'intérieur de manière hermétique contre la surface d'enveloppe (11) de la partie de tête ou de base (3) ou contre le fond de rainure (12) de la rainure (6), et, en cas de hautes températures, s'applique par dilatation axialement de manière hermétique contre les deux flancs de rainure (9) de la rainure (6).

2. Actionneur piézoélectrique selon la revendication 1, **caractérisé en ce que** la saillie (7) remplit complètement la rainure (6).

3. Actionneur piézoélectrique selon la revendication 1 ou 2, **caractérisé en ce que** la partie de tête ou de base (3) a une section transversale angulaire avec des coins arrondis (13).

4. Actionneur piézoélectrique selon la revendication 1 ou 2, **caractérisé en ce que** la partie de tête ou de base (3) présente une section transversale arrondie.

5. Actionneur piézoélectrique selon l'une quelconque des revendications précédentes, **caractérisé en ce que** la partie de tête ou de base (3) présente plusieurs rainures périphériques (6) et, de manière correspondante, le joint d'étanchéité en plastique (5) présente plusieurs saillies (7).

6. Actionneur piézoélectrique selon l'une quelconque des revendications précédentes, **caractérisé en ce que** le joint d'étanchéité en plastique (5) s'étend jusqu'à l'élément piézoélectrique (2).
